# EUROPEAN PATENT SPECIFICATION

(11) **EP 2 873 467 B1**
(45) Date of publication and mention of the grant of the patent: **08.11.2017**
(21) Application number: 12888515.9
(22) Date of filing: 15.11.2012
(51) Int. Cl.: B08B 7/00, C23C 14/56, B24C 1/00

(54) **ADHERED-MATTER REMOVING DEVICE AND VAPOR DEPOSITION SYSTEM**
VORRICHTUNG ZUR ENTFERNUNG EINES HAFTENDEN MATERIALS SOWIE DAMPFABSCHEIDUNGSSYSTEM
DISPOSITIF DE RETRAIT DE SUBSTANCE EN ADHÉSION ET SYSTÈME DE DÉPÔT EN PHASE VAPEUR

(43) Date of publication of application: 20.05.2015
(73) Proprietor: Mitsubishi Heavy Industries, Ltd., Tokyo 108-8215 (JP)
(72) Inventor: ARAI Satoshi, Tokyo 108-8215 (JP); SHIGEOKA Nobuyuki, Tokyo 108-8215 (JP)
(74) Representative: Hoffmann Eitle
(86) International application number: PCT/JP2012/079650
(87) International publication number: WO 2014/076794

(56) References cited:
- WO-A1-2012/127981
- JP-A- H04 206 521
- JP-A- 2004 223 410
- JP-A- 2006 351 595
- JP-A- 2007 117 838
- JP-A- 2008 281 332
- JP-A- 2009 060 029
- JP-A- 2009 131 743
- JP-A- 2009 131 743
- JP-B2- 4 166 664
- US-A- 5 209 028
- LAYDEN L ET AL: "HIGH VELOCITY CARBON DIOXIDE SNOW FOR CLEANING VACUUM SYSTEM SURFACES", JOURNAL OF VACUUM SCIENCE AND TECHNOLOGY: PART A, AVS /AIP, MELVILLE, NY., US, vol. 8, no. 5, 1 September 1990 (1990-09-01), pages 3881-3883, XP000147913, ISSN: 0734-2101, DOI: 10.1116/1.576465

## Description

### [Technical Field]

This invention relates to an adhered substances removing device for removing matter having adhered to a workpiece, a vapor deposition system using such an adhered substances removing device, and a removal method of removing the adhered substances using such an adhered substances removing device.

### [Background Art]

In vapor deposition apparatuses used for production lines, deposition is carried out while a substrate is continuously conveyed with the substrate mounted on a tray to which a mask for deposition is attached. While the tray and the mask are repetitively subjected to cyclic use, a deposition material is accumulated on the tray and the mask. If the deposition material is increased in thickness, the deposition material is released in the apparatus, and contaminates the interior and exterior of a deposition chamber. For this reason, the tray and the mask are exchanged after being used a fixed number of times.

After the deposition onto the substrate, if the deposited matter on the tray and the mask can be removed in a return section to which the tray and the mask are cycled, it is unnecessary to exchange the tray and the mask after the tray and the mask are used a fixed number of times, and it is possible to increase productivity. For this reason, several means for removing the deposited matter on the tray and the mask have been known. To be specific, an apparatus in which dry ice is used in a vacuum chamber is described in Japanese Patent (Granted) Publication No. 4166664. Sublimated dry ice particles are used, and thereby deposited matter can be released without damaging the tray and the mask that are targets to be injected, unlike sandblasting or glass bead blasting. Further, the apparatus described in Japanese Patent (Granted) Publication No. 4166664 injects dry ice to remove a deposited matter in a vacuum mask stock chamber in a cluster device without exposing the deposited matter accumulated on the mask to the air. Further, a method of separately providing a vacuum plasma processing chamber in a vacuum return fashion is described in Japanese Patent (Granted) Publication No. 4096353. A removal method of combining a laser releasing method and a film adhering method is described in Japanese Patent (Granted) Publication No. 4236632.

JP 2008 281332 A describes the removal of incineration ash by blowing by means of an injection nozzle dry ice grain upon a cleaning object surface. The dry ice grain hitting the cleaning object surface changes to gas leading to a cubical expansion caused by vaporization. By this action, the objects to be removed from the object surface are blown away and the dry ice grain is finally completely vanished.

The apparatus and method according to WO 2012/127981 A1 uses a particulate injection unit with a particulate which sublimates. The particulate is injected from a nozzle toward the workpiece. Further, a dry gas supplying unit is provided, which is configured to supply dry gas to the atmosphere in which the particulate is injected onto the workpiece.

In the scientific paper LAYDEN L ET AL: "HIGH VELOCITY CARBON DIOXIDE SNOW FOR CLEANING VACUUM SYSTEM SURFACES", JOURNAL OF VACUUM SCIENCE AND TECHNOLOGY: PART A, AVS/ AIP, MELVILLE, NY., US, vol. 8, no. 5, 1 September 1990 (1990-09-01), pages 3881-3883, XP000147913, ISSN:0734-2101, DOI:10.1116/1.576465 an apparatus and method are described for removing adhered substances from a workpiece. By means of an injection nozzle, a particulate, which sublimates in an atmosphere, is injected toward the workpiece. Further, a dry gas supplying unit is configured to supply dry gas to the atmosphere in which the particular is injected onto the workpiece. The particles are injected under an angle with respect to the surface to be cleaned.

US 5,209,028 A discloses an apparatus for cleaning semiconductor solid surfaces using a spray of frozen cryogen, such as argon, to impinge on the solid surface to remove contaminant particles. US 5,209,028 A discloses features falling under the preamble of claim 1.

### [Technical Problem]

However, in the apparatus described in Japanese Patent (Granted) Publication No. 4166664, there is a problem in that the vacuum chamber provided for the return section makes the apparatus expensive. Further, when the deposited matter is released in the vacuum atmosphere, this leads to a problem such as difficulty in recovery and exhausting of a released residual quantity or degradation in a vacuum seal due to use of 03.

The method described in Japanese Patent (Granted) Publication No. 4096353 is a method that can be applied to the return section. However, in addition to difficulty in exhausting with regard to the vacuum return fashion, the removal of the deposited matter based on the vacuum plasma method makes the apparatus more complicated and expensive.

The method described in Japanese Patent (Granted) Publication No. 4236632 is a method of applying a laser to release the deposited matter with a transparent film attaching to the mask and preventing the released deposited matter from being scattered to the surroundings by the film, and can be used even in air. However, the film attaching method is applicable to a thin film, but it is difficult to attach the film to a workpiece that has a complicated shape and combines the tray for the conveyance and the mask in the return section.

Accordingly, the deposited matter is released by injecting the dry ice in the air, thereby making it possible to obtain an inexpensive constitution. However, if the particulate sublimated in the atmosphere, such as the dry ice particles, is injected on the workpiece such as the tray or the mask in the air, the workpiece is cooled, and moisture in the air is condensed into dew. If the moisture is further cooled by injecting the particulate sublimated in the atmosphere, the moisture is frozen, and continuous releasing is impossible. This is also confirmed by a test.

The present invention has been made to improve the aforementioned problems, and an object of this invention is to provide an adhered substances removing device capable of continuously removing adhered substances of a workpiece without being affected by the influence of moisture, a vapor deposition system using such an adhered substances removing device, and a removal method of removing the adhered substances using such an adhered substances removing device.

### [Solution to Problem]

To solve the aforementioned problem, the present invention proposes a device with the features of claim 1. Preferred embodiments follow from the other claims.

An adhered substances removing device of the present invention is a device for removing adhered substances adhered to a workpiece, and includes a particulate injecting unit injects a particulate, which sublimates in an atmosphere from an injection nozzle toward the workpiece, and releases the adhered substances from the workpiece; and a dry gas supplying unit that supplies dry gas to the atmosphere in which the particulate is injected onto the workpiece by the particulate injecting unit.

According to this constitution, the adhered substances adhered to the workpiece can be removed by the particulate which the particulate injecting unit injects. In this case, since the particulate is a material which sublimates in the atmosphere, the injected particulate does not remain behind to damage the workpiece, and further the particulate is not liquefied to contaminate the workpiece and its surrounds. In this way, the adhered substances can be removed. Further, the dry gas is supplied into the atmosphere by the dry gas supplying unit. Thereby, when the workpiece is cooled by injecting the particulate which sublimates in the atmosphere toward the workpiece using the particulate injecting unit, no moisture is contained in the atmosphere, and thus no moisture is condensed on the workpiece. For this reason, the moisture in the atmosphere is not frozen on the workpiece, and the adhered substances can be continuously removed by the particulate which sublimates in the atmosphere without being affected by the influence of the moisture even in such an environment, such as the air, in which the moisture is contained.

Further, in the adhered substances removing device of the present invention, the particulate injecting unit injects the particulate so as to be inclined with respect to a face to which the adhered substances is adhered in the workpiece.

According to this constitution, the matter having adhered to the workpiece can be blown off in a roughly constant direction.

Further, the adhered substances removing device of the present invention further includes a cover that covers at least the injection nozzle of the particulate injecting unit and the atmosphere in which the particulate is injected on the workpiece, and is open toward the workpiece.

According to this constitution, since the atmosphere in which the particulate is injected on the workpiece is covered by a cover, the atmosphere is reliably filled with supplied dry gas.

Further, the adhered substances removing device of the present invention further includes a suction unit that is connected to the cover and suctions a material in the cover.

According to this constitution, the particulate sublimated in the atmosphere or the released adhered substances can be recovered. It is possible to recycle the particulate which sublimates in the atmosphere or to prevent the released adhered substances from being scattered.

Further, the adhered substances removing device of the present invention further includes a heater for heating a place at which the adhered substances on the workpiece is to be removed.

According to this constitution, after the adhered substances is removed, when the workpiece is conveyed into the air, it is possible to prevent the moisture in the air from being cooled by the low-temperature workpiece and condensed on the workpiece.

Further, in the adhered substances removing device of the present invention, the heater is configured of the dry gas which is heated.

According to this constitution, it is possible to heat the workpiece without using a separate medium for heating the workpiece. As such, the constitution of the device can be more simplified.

Further, the adhered substances removing device of the present invention further includes a moving unit for relatively moving the injection nozzle of the particulate injecting unit with respect to the workpiece in at least one direction.

According to this constitution, the adhered substances can be removed throughout the workpiece by a smaller number of particulate injecting unit.

Further, the adhered substances removing device of the present invention includes a plurality of particulate injecting unit.

According to this constitution, the removal of the adhered substances on the workpiece can be performed more rapidly or more reliably.

Further, in the adhered substances removing device of the present invention, the plurality of particulate injecting unit are mounted toward the same place of the workpiece at different solid angles.

According to this constitution, since the particulate can be injected on the same place in different directions, it is possible to cope with the removal of the adhered substances on the workpiece having a complicated shape.

Further, a vapor deposition system of the present invention includes the aforementioned adhered substances removing device and a vapor deposition apparatus deposited a deposition material onto a deposition target material that is supported and conveyed by a support that is the workpiece supporting the deposition target material.

According to this constitution, a process of performing deposition onto the deposition target material, a process of releasing matter deposited to a support that supports the deposition target material, and a process of supporting a new deposition target material on the support can be continuously performed.

Further, the vapor deposition system of the present invention further includes a residue removing unit that is disposed downstream in a conveying direction of the support with respect to the adhered substances removing device and removes a residue remaining on the support from which the adhered substances has been removed by the adhered substances removing device.

According to this constitution, after the adhered substances on the workpiece are removed, the residue remaining on the workpiece is removed by the residue removing unit. As such, the adhered substances on the workpiece can be reliably removed without any remaining behind.

### [Advantageous Effects of Invention]

According to the adhered substances removing device of the present invention, the removal of the adhered substances of the workpiece can be continuously performed by injecting the particulate, such as dry ice, which sublimates in the atmosphere without being affected by the influence of the moisture in the air.

Further, according to the vapor deposition system of the present invention, the removal of the deposition material having adhered to the support that is the workpiece can be continuously performed by injecting the particulate, such as dry ice, which sublimates in the atmosphere without being affected by the influence of the moisture in the air.

### [Brief Description of Drawings]

Fig. 1 is a schematic view showing a vapor deposition system.
Fig. 2 is a constitutional view of a substrate, a mask, and a tray in the vapor deposition system.
Fig. 3A is a schematic view showing a vapor deposition apparatus in the vapor deposition system.
Fig 3B is a front view of the vapor deposition apparatus shown in Fig. 3A.
Fig. 3C is a view showing a bottom of the deposited tray in the vapor deposition apparatus shown in Fig. 3A.
Fig. 4 is a schematic view showing an air return conveyor in the vapor deposition system.
Fig. 5 is a schematic view showing an adhered substances removing device.
Fig. 6 is a schematic view showing another aspect of the adhered substances removing device.
Fig. 7 is a schematic view showing releasing adhered substances using a dry ice injecting unit.
Fig. 8A is a schematic view showing an XY stage of the adhered substances removing device.
Fig. 8B is a view showing a traveling path of the dry ice injecting unit based on the XY stage.
Fig. 8C is a schematic view showing the dry ice injecting unit that does not require the XY stage.
Fig. 9A is a schematic view showing a first embodiment of the adhered substances removing device.
Fig. 9B is a schematic view showing a modified example of the first embodiment of the adhered substances removing device.
Fig. 10 is a schematic view showing a second embodiment of the adhered substances removing device according to the present invention.
Fig. 11 is a schematic view showing a third embodiment of the adhered substances removing device.
Fig. 12 is a schematic view showing a fourth embodiment of the adhered substances removing device according to the present invention.

### [Description of Embodiments]

Hereinafter, embodiments according to the present invention will be described with reference to the appended drawings.

### [First embodiment]

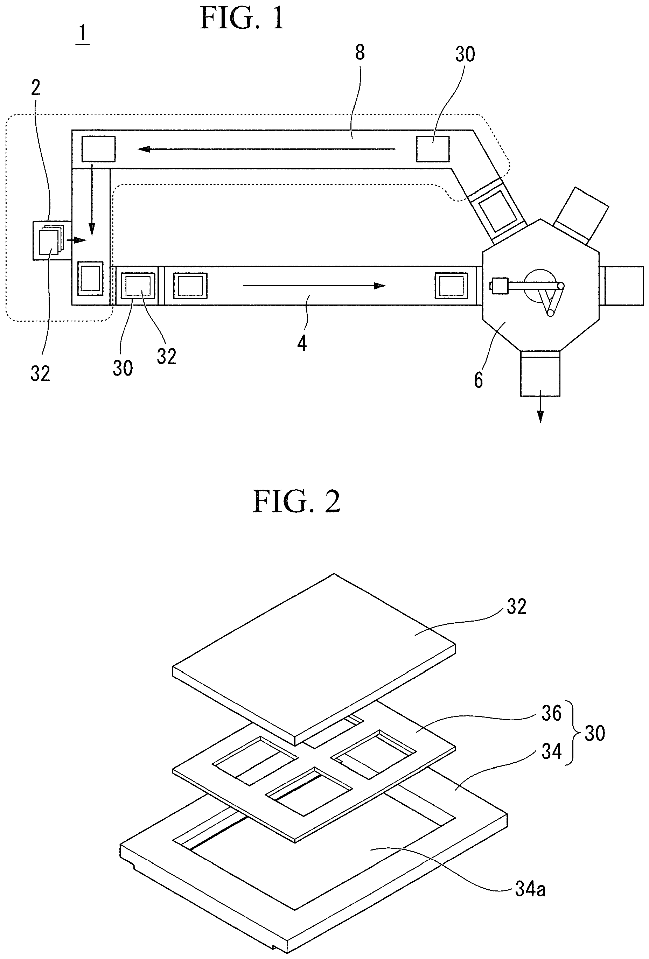

A vapor deposition system 1, shown in Fig. 1, includes a tray/substrate superimposition section 2 that disposes a substrate 32, which is a
deposition target material, on a tray 34 that is a support, a vapor deposition apparatus 4 that forms an organic film on the substrate 32 disposed on the tray 34, a substrate distribution section 6 that removes the substrate 32 on which the organic film is formed from the tray 34 and distributes the substrate 32 to the next process, and an air return section 8 that returns the tray 34 from which the substrate 32 is removed to the tray/substrate superimposition section 2 again.

As shown in Fig. 2, the tray 34 is a plate-like member, in the middle of which a through-hole 34a is formed. Further, the tray 34 is mounted with a mask 36 restricting a region of the organic film formed on the substrate 32. Thus, the substrate 32 is disposed and supported on the mask 36 mounted on the tray 34 using the tray 34 and the mask 36 as a support in the tray/substrate superimposition section 2 such that a deposition region is exposed from the opposite side through the mask 36 and the through-hole 34a. For example, the tray 34 is formed of a metal plate having a thickness of several millimeters, and the mask 36 is formed of a metal sheet having a thickness of about 0.1 mm.

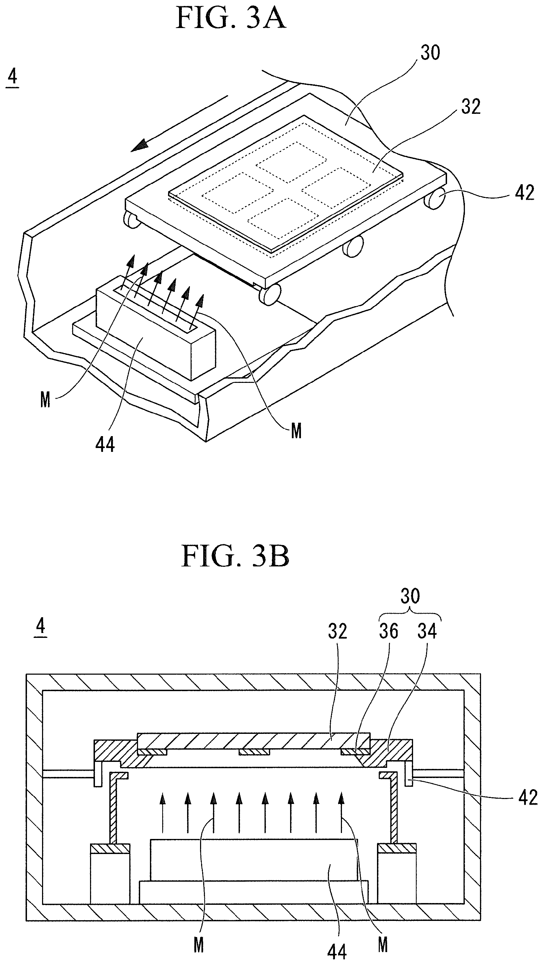

As shown in Figs. 3A and 3B, the vapor deposition apparatus 4 includes a conveyance unit such as conveyance rollers 42 that convey the substrate 32 supported on the tray 34, and an evaporation source 44 that is disposed below the conveyed substrate 32. The evaporation source 44 evaporates or sublimates a depositing material M to eject it upward. The ejected depositing material M is deposited onto the substrate 32, and adheres to the tray 34 supporting the substrate 32 and the mask 36 that is installed on the tray 34 and restricts a deposition range of the substrate 32.

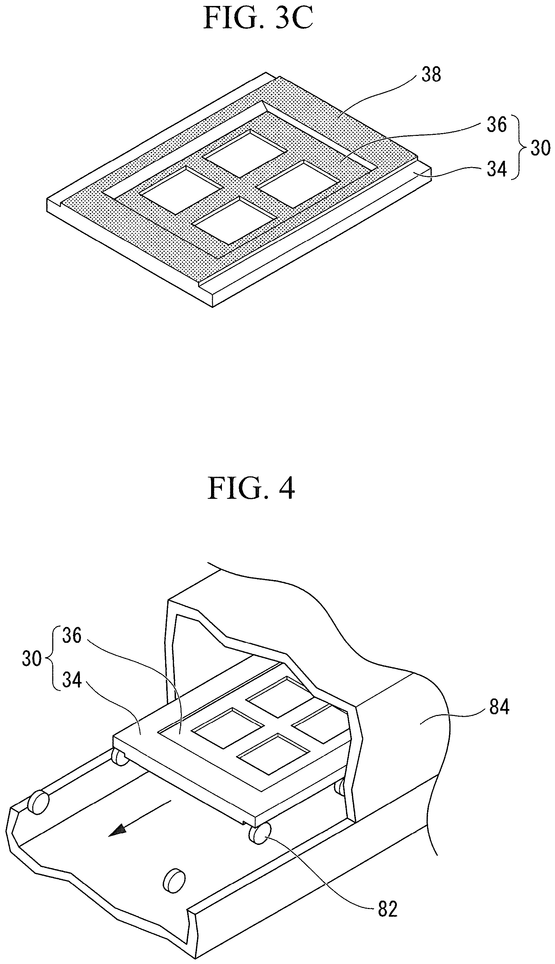

As shown in Fig. 4, in the present embodiment, as an example of a specific constitution, the air return section 8 includes a conveyance unit such as conveyance rollers 82 that convey the tray 34 and the mask 36 in the atmosphere, and a cover 84 for clean environment preservation.

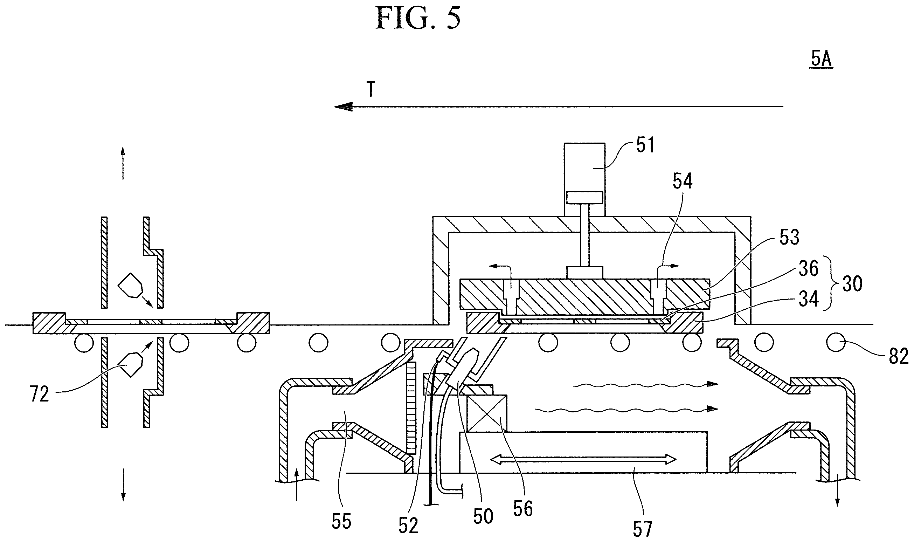

Further, the vapor deposition system 1 includes an adhered substances removing device 5A shown in Fig. 5 in order to remove the organic film 38 formed of the depositing material M having adhered to a workpiece 30. In the present embodiment, the workpiece 30 is made up of the tray 34 and the mask 36. Further, in the present embodiment, the adhered substances removing device 5A is provided within the air return section 8.

As shown in Fig. 5, the adhered substances removing device 5A includes a pad plate 53 that is movable up and down by an air cylinder 51 and includes vacuum chucks 54, a dry ice injecting unit 50 that is a particulate injecting unit for injecting dry ice particles acting as a particulate in order to release the organic film that is the adhered substances, XY stages 56 and 57 that constitute a moving unit for moving an injection nozzle 500 of the dry ice injecting unit 50, a supply/exhaust unit 55 for keeping an interior of the adhered substances removing device 5A clean, and an air blower 72 that is a residue removing unit installed downstream in a conveying direction.

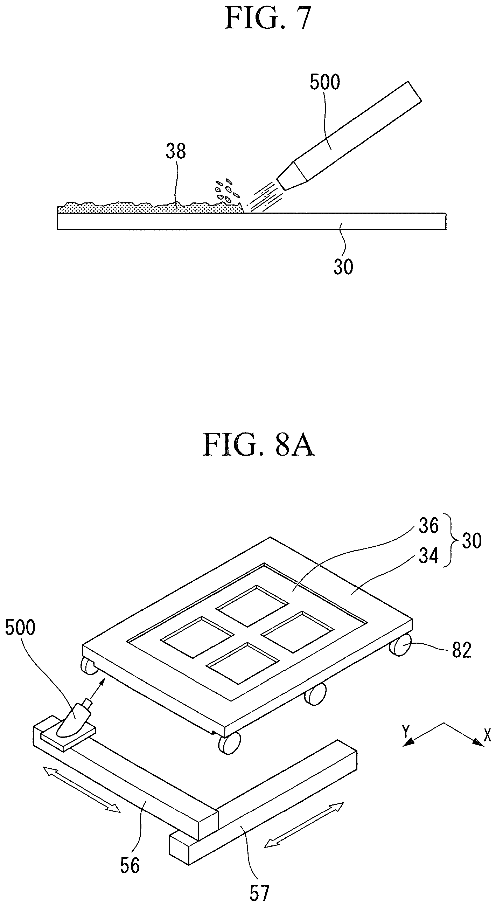

As shown in Fig. 7, the injection nozzle 500 of the dry ice injecting unit 50 is installed inclined with respect to the workpiece 30.

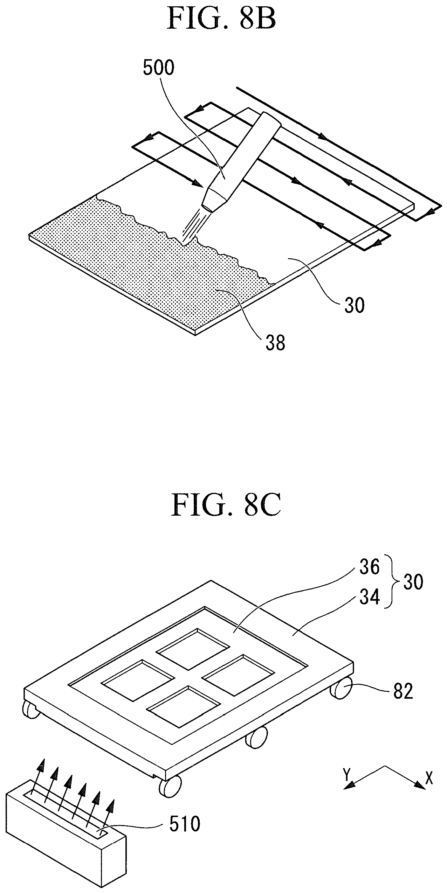

As shown in Fig. 8A, the XY stages 56 and 57 are configured to move the injection nozzle 500 of the dry ice injecting unit 50 so as to be able to inject dry ice on the entire surface of the workpiece. In detail, the injection nozzle 500 of the dry ice injecting unit 50 in the first embodiment is configured to be moved along arrows shown in Fig. 8B by the XY stages 56 and 57.

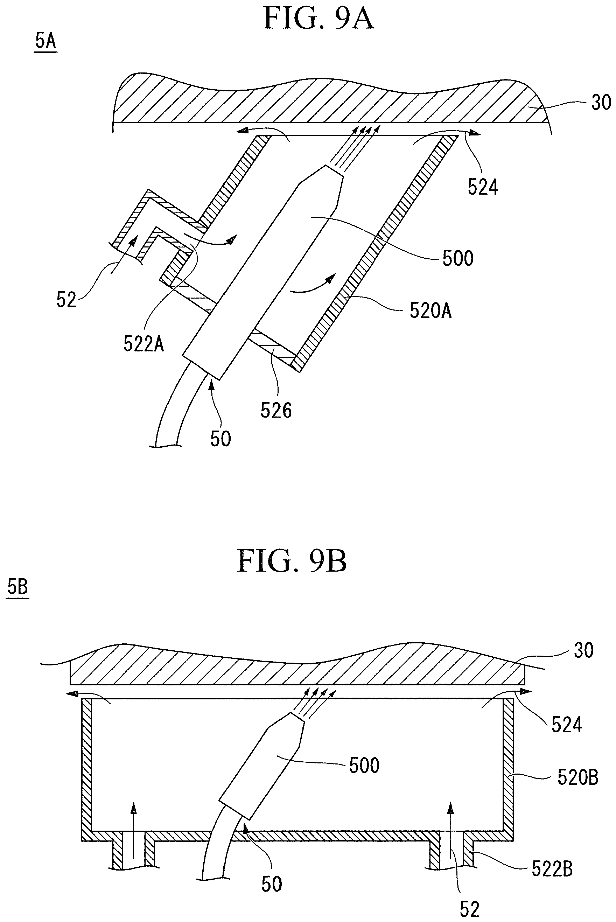

Referring to Fig. 9A, the adhered substances removing device 5A in the first embodiment further includes a cylindrical atmosphere cover 520A that at least covers the injection nozzle 500 of the dry ice injecting unit 50 and an atmosphere in which dry gas is injected onto the workpiece 30, and a dry gas supplying unit 52 that supplies the dry gas into a region covered by the atmosphere cover 520A. An end of the atmosphere cover 520A which faces the workpiece 30 is open, and is disposed to have a gap 524 at a predetermined distance from the workpiece 30. Further, the other end of the atmosphere cover 520A is sealed by a seal material 526. In addition, the atmosphere cover 520A is provided with a dry gas supply port 522A.

According to the aforementioned constitution, the substrate 32 on which no deposition is performed is disposed under the tray 34 and the mask 36 in the tray/substrate superimposition section 2, and as shown in Figs. 3A and 3B, the substrate 32 supported on the tray 34 is conveyed into the vapor deposition apparatus 4 by the conveyance unit such as the conveyance rollers 42. The substrate 32 continuously passes over the evaporation source 44, and thereby the organic film is continuously deposited on a lower surface of the substrate 32. Fig. 3C illustrates bottoms of the tray 34 and the mask 36 to which the deposition material has adhered. When the deposition is performed on the substrate 32, the deposition material 38 also adheres to the tray 34 and the mask 36 covering a part of the substrate 32.

The substrate 32 deposited in the vapor deposition apparatus 4 is removed from the tray 34 and the mask 36 in the substrate distribution section 6, and is distributed to the next process. As shown in Fig. 4, the tray 34 and the mask 36 from which the substrate 32 is removed is conveyed into the adhered substances removing device 5A, which is installed on the air return section 8 covered with the cover 84 for clean environment preservation, by a conveyance unit such as conveyance rollers 82.

First, the tray 34 and the mask 36 that are the workpiece 30 conveyed into the adhered substances removing device 5A by rollers come into surface contact with the pad plate 53 lowered by the air cylinder 51, and are flatly fixed to the pad plate 53 by the vacuum chucks 54. Subsequently, when the organic film on the workpiece 30 is released, a space covered by the atmosphere cover 520A is filled with the dry gas supplied from the dry gas supply port 522A first (dry gas supplying step in a removal method of removing adhered substances). Next, the dry gas is injected toward the workpiece 30 (particulate injecting step). The organic film released by injecting the dry gas is ejected from the gap 524 outside the atmosphere cover 520A along with the injected dry ice and the supplied dry gas.

The XY stages 56 and 57 make it possible to move the injection nozzle 500 of the dry ice injecting unit 50 and to release the organic film throughout the tray 34 and the mask 36. In the first embodiment, as shown in Fig. 8A, the injection nozzle 500 of the dry ice injecting unit 50 is moved as indicated by an arrow of Fig. 8B by the XY stages 56 and 57, and the organic film 38 is released throughout the workpiece 30. The supply/exhaust unit 55 is installed in the adhered substances removing device 5A and causes clean air to flow in one direction. Thereby, CO₂ that is the dry ice, the dry gas, and the released organic film can be moved and recovered in one direction. The tray 34 and the mask 36 from which the organic film is released are conveyed in a direction of arrow T by the rollers, and the residues of the released organic film on the tray 34 and the mask 36 are blown off by an air blower.

The tray 34 and the mask 36 from which the organic film is removed are returned to the tray/substrate superimposition section 2 again. Thereby, it is possible to circulate the depositing and releasing processes.

The workpiece 30 is cooled by injecting the dry ice. However, since the atmosphere is filled with the dry gas, there is no dew condensation on the workpiece 30 due to a temperature difference between the atmosphere and the workpiece 30. For this reason, without condensed moisture being frozen by the injecting of the dry ice to impede the releasing of the organic film on the workpiece 30, the organic film can be continuously released with respect to the continuously conveyed workpiece 30.

When the dry ice is injected, the workpiece 30 is flatly fixed to the pad plate 53 by the vacuum chucks 54. Thereby, the tray 34 or the mask 36 can be prevented from being deformed and damaged by a pressure under which the dry ice is injected.

Further, the dry ice is injected obliquely on the workpiece 30. Thereby, it is possible to blow the released organic film 38 in one direction and to efficiently recover the released organic film 38.

The particulate sublimated in the atmosphere is not limited to the dry ice. As other particulate sublimated in the atmosphere, particulate such as nitrogen may be used.

The workpiece and the injection nozzle of the dry ice injecting unit may be relatively moved. When an injection port 510 for injecting the dry ice over the full length of the workpiece in an X direction is employed as shown in Fig. 8C, it is possible to release the organic film 38 of the entire region of the workpiece 30 while the workpiece 30 is moved in a Y direction by the conveyance rollers, without moving the injection nozzle. In this case, the XY stages 56 and 57 are not required. The injection port 510 may be a injection port shaped of one elongated slit, or may be made up of multiple injection nozzles disposed linearly.

The atmosphere cover 520A shown in Fig. 9A, in order to obtain the dry gas atmosphere, is formed to locally cover the portion of the injection nozzle 500 of the dry ice injecting unit 50. However, as shown in Fig. 9B, an atmosphere cover 520B which covers a wider range, to which the dry gas is supplied from multiple dry gas supply ports 522B, and which is not a cylindrical shape may be used. Especially, the atmosphere cover 520B is advantageous when the injection port 510 shown in Fig. 8C is employed.

### [Second embodiment]

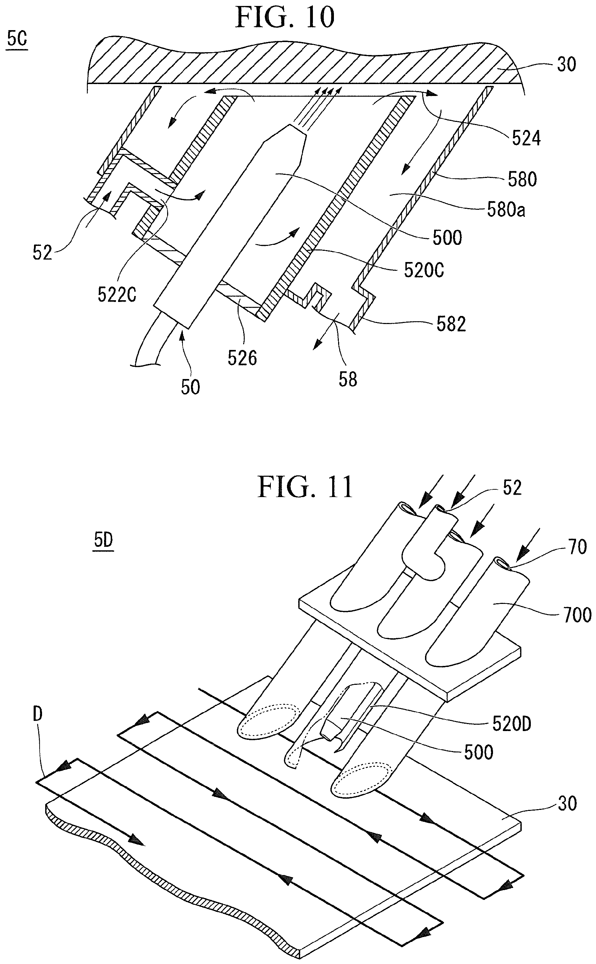

A second embodiment of the adhered substances removing device will be described with reference to Fig. 10. Like the adhered substances removing device 5A in the first embodiment, the adhered substances removing device 5C in the second embodiment includes a dry ice injecting unit 50, an atmosphere cover 520C, and a dry gas supplying unit 52. In the second embodiment, the adhered substances removing device 5C further includes a cylindrical suction cover
580 that covers the atmosphere cover 520C, and a suction means 58 that suctions an atmosphere from a space 580a defined by the atmosphere cover 520C and the suction cover 580. In the suction cover 580, one end thereof faces a workpiece 30 and is open, and the other end thereof is provided with a suction port 582. Further, the suction cover 580 has approximately the same length as the atmosphere cover.

According to this constitution, in conjunction with carrying out a particulate injecting step using the dry ice injecting means 50, suction caused by the suction unit 58 is performed as a suctioning step. An organic film released by injecting dry ice is ejected from a gap 524 between the workpiece 30 and the atmosphere cover 520C by the suction unit 58 along with the dry ice and dry gas, and is suctioned from the suction port 582 via the space 580a defined by the atmosphere cover 520C and the suction cover 580.

By providing the suction cover 580 and the suction unit 58, the dry ice, the dry gas, and the released organic film, which are ejected from the gap 524 between the workpiece 30 and the tubular cover to outside the atmosphere cover during the releasing of the organic film, can be suctioned from the suction port 582. Due to the suction unit 58, CO2 that is a relatively expensive dry ice can be recovered and recycled, or the released organic film can be recovered without scattering the released organic film.

### [Third embodiment]

A third embodiment of the adhered substances removing device according to the present invention will be described with reference to Fig. 11. Like the adhered substances removing device 5A in the first embodiment, the adhered substances removing device 5D in the third embodiment includes a dry ice injecting unit 50, a cylindrical atmosphere cover 520D, and a dry gas supplying unit 52. Further, the adhered substances removing device 5D in the third embodiment further includes two cylindrical warm-air covers 700 and a warm-air supplying unit 70 that is a heater. In the present embodiment, the two cylindrical warm-air covers 700 are disposed at front and rear sides in a direction in which an injection nozzle 500 of the dry ice injecting unit 50 is moved with respect to a position injected by the dry ice injecting unit 50. Ends of the two warm-air covers 700 which are opposite to the workpiece 30 are open, and are cut obliquely so as to correspond to an inclination of the injection nozzle 500. Warm air is supplied from the other ends of the two warm-air covers 700 by the warm-air supplying unit 70.

In this constitution, when the dry ice injecting unit 50 moves along an arrow D shown in Fig. 11 while releasing an organic film, as a heating step, the warm air from the warm-air supplying unit 70 is sent to the front and rear sides in the direction in which the injection nozzle 500 of the dry ice injecting unit 50 is moved with respect to a region where dry ice is injected at the workpiece 30, and the workpiece 30 is heated. For this reason, the workpiece 30 is heated by the warm-air supplying unit 70 just before the dry ice is injected by the dry ice injecting unit 50, and then the dry ice is injected. Thereby, it is possible to inhibit a temperature from being lower than that of an ambient atmosphere. Further, the workpiece 30 is heated by the warm-air supplying unit 70 just after the dry ice is injected and the workpiece is cooled. Thereby, a place at which the workpiece 30 is cooled by the dry ice can be returned to room temperature or higher.

As described above, due to the dry gas supplying unit 52, no dew condensation occurs at the place of the workpiece 30 which is covered with the atmosphere cover. However, when the released place of the workpiece 30 is exposed to the air with the movement of the dry ice injecting unit 50, moisture in the air may be condensed on the workpiece due to a difference between the temperature of the workpiece 30 cooled by the injecting of the dry ice and an environmental temperature. Such dew condensation can be prevented by heating the workpiece 30 using the warm-air supplying unit 70.

The unit for coping with the cooling of the workpiece 30 resulting from the injecting of the dry ice may also be carried out on other aspects.

For example, in the first, second, and third embodiments, the dry gas itself supplied by the dry gas supplying unit 52 may be warmed and supplied. Due to the supply of the warmed dray gas, it is possible to prevent the dew condensation on the workpiece 30 during the injecting of the dry ice as well as inhibit the workpiece 30 from being cooled. Further, the unit for heating the workpiece 30 in this way can be used in combination with the unit for supplying the dry gas. Thereby, it is unnecessary to newly provide the heater, and it is possible to suppress costs of the apparatus.

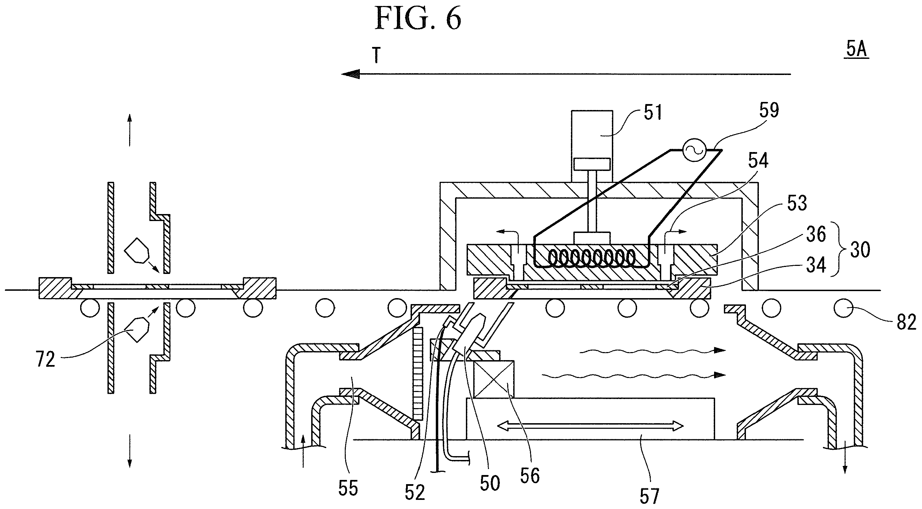

Another unit for coping with the cooling of the workpiece 30 resulting from the injecting of the dry ice is shown in Fig. 6. That is, a heater 59 for heating the workpiece 30 is embedded in the pad plate 53, and the dry ice can be injected while the workpiece 30 is heated from an adsorption face, i.e. the opposite side of a surface to which the dry ice is injected.

### [Fourth embodiment]

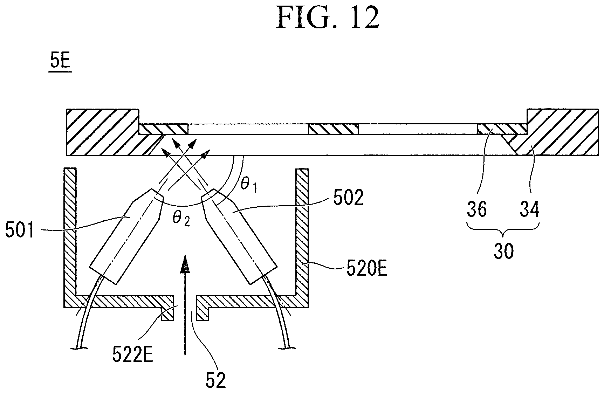

A fourth embodiment of the adhered substances removing device according to the present invention will be described with reference to Fig. 12. Like the adhered substances removing device 5B in the first embodiment, the adhered substances removing device 5E in the fourth embodiment includes a cylindrical atmosphere cover 520E and a dry gas supplying unit 52. Further, the adhered substances removing device 5E in the fourth embodiment includes first and second dry ice injection nozzles 501 and 502. The first and second injection nozzles 501 and 502 are disposed to inject dry ice on the same place on the workpiece 30, and are fixed at different solid angles *θ*₁ and *θ*₂ with respect to a reference plane of the workpiece 30. The other parts of the constitution comply with the first, second, and third embodiments.

In this configuration, the first injection nozzle 501 is mainly used to release an organic film deposited on a horizontal plane of the workpiece 30, and the second injection nozzle 502 is oriented to efficiently release the organic film from a predetermined oblique face of the workpiece 30.

If the entire surface of the workpiece 30 include a three-dimensional surface rather than a flat surface, injecting the dry ice in one direction cannot efficiently release the organic film on the three-dimensional plane, or cannot release the organic film at all. In this case, the dry ice is injected from the second injection nozzle 502 oriented at another solid angle corresponding to the three-dimensional plane, and thereby the organic film on the workpiece 30 can be released by one scanning.

The adhered substances removing device may be equipped with three or more injection nozzles depending on the shape of the workpiece 30. The dry ice is injected toward the same place on a target at different solid angles, and thereby the organic film can be efficiently released with respect to the workpiece having a more complicated shape.

The vapor deposition system and the adhered substances removing device of the present invention are not limited to each embodiment, and modification and improvement thereof can be adequately made.

### [Industrial Applicability]

The present invention is directed to an adhered substances removing device capable of continuously removing adhered substances of a workpiece without being affected by the influence of moisture, a vapor deposition system using such an adhered substances removing device, and a removal method of removing the adhered substances using such an adhered substances removing device.

### [Reference Signs List]

1: vapor deposition system
2: tray/substrate superimposition section
4: vapor deposition apparatus
5A, 5B, 5C, 5D, 5E: adhered substances removing device
6: substrate distribution section
8: air return section
30: workpiece (tray and mask)
32: substrate (deposition target material)
34: tray
36: mask
38: deposition material, organic film
42, 82: conveyance roller
44: evaporation source
50: dry ice injecting unit
51: air cylinder
52: dry gas supplying unit
53: pad plate
54: vacuum chuck
55: supply/exhaust unit
56: X stage
57: Y stage
58: suction unit
59: heater
70: warm-air supplying unit
72: air blower
84: cover
500: injection nozzle
501: first injection nozzle
502: second injection nozzle
510: injection port
520A, 520B, 520C, 520D, 520E: atmosphere cover
522A, 520B, 520C, 520D, 520E: (dry gas) supply port
524: gap
526: seal material
580: suction cover
582: suction port
700: warm-air cover

## Claims

1. An adhered substances removing device (5D) for removing organic films formed of a depositing material adhered to a workpiece (30) which is arranged to move in a Y-direction, the adhered substances removing device comprising:
a particulate injection unit (500) configured to inject a particulate, which sublimates in an atmosphere, from an injection nozzle toward the workpiece (30), and to release the organic films from the workpiece; and
a dry gas supplying unit (52) configured to supply dry gas to the atmosphere in which the particulate is injected onto the workpiece by the particulate injection unit,
**characterized in that**
the adhered substances removing device comprises
a heater (70) configured to heat a spot at which the adhered substances on the workpiece are to be removed by supplying warm air,
two warm-air covers (700) by which the warm air is supplied by the heater; and
a moving unit (56, 57) configured to relatively move the injection nozzle of the particulate injection unit (500) with respect to the workpiece in at least one direction,
the moving unit (56, 57) being configured to move in an X-direction ,
wherein the warm-air covers (700) are arranged to be moved together with the injection nozzle,
wherein an end of the warm-air covers (700) which is opposite to the workpiece is open,
wherein the warm-air covers (700) are disposed on opposing sides of the injection nozzle (500) in the X-direction so as to sandwich the injection nozzle (500).

2. The adhered substances removing device according to claim 1, wherein the particulate injection unit (500) injects the particulate so as to be inclined with respect to a face to which the adhered substances are adhered in the workpiece (30).

3. The adhered substances removing device according to claim 1 or 2, further comprising a cover (520D) configured to cover at least the injection nozzle (500) of the particulate injection unit and the atmosphere in which the particulate is injected on the workpiece, and to be open toward the workpiece (30).

4. The adhered substances removing device according to claim 3, further comprising a suction unit configured to be connected to the cover (520D) and to suction a material in the cover.

5. The adhered substances removing device according to any one of claims 1 to 4, wherein the heater is configured to heat the dry gas.

6. The adhered substances removing device according to any one of claims 1 to 5, wherein the adhered substances removing device includes a plurality of the particulate injection units (500).

7. The adhered substances removing device according to claim 6, wherein the plurality of the particulate injection units (500) are mounted toward the predetermined spot of the workpiece at different solid angles.

8. A vapor deposition system comprising:
the adhered substances removing device according to any one of claims 1 to 7; and
a vapor deposition apparatus (4) configured to deposit a deposition material onto a deposition target material (32) that is supported and conveyed by a support that is the workpiece (30).

9. The vapor deposition system according to claim 8, further comprising a residue removing unit configured to be disposed downstream in a conveying direction of the support with respect to the adhered substances removing device and to remove a residue remaining on the support from which the adhered substances has been removed by the adhered substances removing device.

## Patentansprüche

1. Anhaftende Stoffe beseitigende Vorrichtung (5D) zum Beseitigen von organischen Belägen, die aus einem an einem Werkstück (30) anhaftenden Abscheidungsmaterial bestehen, die so angeordnet ist, dass sie sich in eine Y-Richtung bewegt, wobei die anhaftende Stoffe beseitigende Vorrichtung umfasst:
eine Partikeleinspritzeinheit (500), die zum Spritzen eines in einer Atmosphäre sublimierenden Partikelstoffs aus einer Spritzdüse auf das Werkstück (30) und zum Lösen der organischen Beläge von dem Werkstück konfiguriert ist; und
eine Trockengas zuführende Einheit (52), die zum Zuführen von Trockengas in die Atmosphäre, in der der Partikelstoff durch die Partikeleinspritzeinheit auf das Werkstück gespritzt wird, konfiguriert ist,
**dadurch gekennzeichnet, dass**
die anhaftende Stoffe beseitigende Vorrichtung umfasst
eine Heizung (70), die so konfiguriert ist, dass sie eine Stelle erwärmt, von der die anhaftenden Stoffe auf dem Werkstück durch Warmluftzufuhr beseitigt werden sollen,
zwei Warmluftabdeckungen (700), durch die die Warmluft von der Heizung zugeführt wird; und
eine Bewegungseinheit (56, 57), die konfiguriert ist, um die Spritzdüse der Partikeleinspritzeinheit (500) relativ in Bezug auf das Werkstück in mindestens eine Richtung zu bewegen,
wobei die Bewegungseinheit (56, 57) konfiguriert ist, um sich in eine X-Richtung zu bewegen,
wobei die Warmluftabdeckungen (700) so angeordnet sind, dass sie sich zusammen mit der Spritzdüse bewegen lassen,
wobei ein dem Werkstück entgegengesetztes Ende der Warmluftabdeckungen (700) offen ist,
wobei die Warmluftabdeckungen (700) an entgegengesetzten Seiten der Spritzdüse (500) in der X-Richtung so angeordnet sind, dass sie die Spritzdüse (500) einklemmen.

2. Anhaftende Stoffe beseitigende Vorrichtung nach Anspruch 1, wobei die Partikeleinspritzeinheit (500) den Partikelstoff so spritzt, dass er in Bezug auf eine Seite, an der die anhaftenden Stoffe an dem Werkstück (30) anhaften, geneigt ist.

3. Anhaftende Stoffe beseitigende Vorrichtung nach Anspruch 1 oder 2, die weiterhin eine Abdeckung (520D) umfasst, die so konfiguriert ist, dass sie mindestens die Spritzdüse (500) der Partikeleinspritzeinheit und die Atmosphäre, in der der Partikelstoff auf das Werkstück gespritzt wird, abdeckt und dass sie zu dem Werkstück (30) hin geöffnet ist.

4. Anhaftende Stoffe beseitigende Vorrichtung nach Anspruch 3, die weiterhin eine Saugeinheit umfasst, die zum Anschließen an die Abdeckung (520D) und zum Ansaugen eines Materials in der Abdeckung konfiguriert ist.

5. Anhaftende Stoffe beseitigende Vorrichtung nach einem der Ansprüche 1 bis 4, wobei die Heizung zum Aufwärmen des Trockengases konfiguriert ist.

6. Anhaftende Stoffe beseitigende Vorrichtung nach einem der Ansprüche 1 bis 5, wobei die anhaftende Stoffe beseitigende Vorrichtung eine Vielzahl von Partikeleinspritzeinheiten (500) aufweist.

7. Anhaftende Stoffe beseitigende Vorrichtung nach Anspruch 6, wobei die Vielzahl der Partikeleinspritzeinheiten (500) in unterschiedlichen Raumwinkeln in Richtung der vorbestimmten Stelle des Werkstücks angebracht ist.

8. Gasphasenabscheidungssystem, umfassend:
die anhaftende Stoffe beseitigende Vorrichtung nach einem der Ansprüche 1 bis 7; und
einen Gasphasenabscheider (4), der zur Abscheidung eines Abscheidungsmaterials auf ein Abscheidungszielmaterial (32) konfiguriert ist, das von einem Träger, der das Werkstück (30) ist, getragen und transportiert wird.

9. Gasphasenabscheidungssystem nach Anspruch 8, das weiterhin eine Rückstandsbeseitigungseinheit umfasst, die so konfiguriert ist, dass sie stromabwärts in Transportrichtung des Trägers in Bezug auf die anhaftende Stoffe beseitigende Vorrichtung angeordnet ist und einen Rückstand beseitigt, der auf dem Träger zurückgeblieben ist, von dem die anhaftenden Stoffe durch die anhaftende Stoffe beseitigende Vorrichtung beseitigt wurden.

## Revendications

1. Dispositif de retrait de substances en adhérence (5D) pour retirer des films organiques formés d'un matériau de dépôt en adhérence sur une pièce à usiner (30) qui est agencé pour se déplacer dans une direction Y, le dispositif de retrait de substances en adhérence comprenant :
une unité d'injection de matière particulaire (500) configurée pour injecter une matière particulaire, qui se sublime dans une atmosphère, d'une buse d'injection vers la pièce à usiner (30), et pour libérer les films organiques de la pièce à usiner ; et
une unité de fourniture de gaz sec (52) configurée pour fournir du gaz sec à l'atmosphère dans laquelle la matière particulaire est injectée sur la pièce à usiner par l'unité d'injection de matière particulaire,
**caractérisé en ce que**
le dispositif de retrait de substances en adhérence comprend
un dispositif de chauffage (70) configuré pour chauffer un point au niveau duquel les substances en adhérence sur la pièce à usiner doivent être retirées par fourniture d'air chaud,
deux recouvrements d'air chaud (700) par lesquels l'air chaud est fourni par le dispositif de chauffage ; et
une unité de déplacement (56, 57) configurée pour déplacer relativement la buse d'injection de l'unité d'injection de matière particulaire (500) par rapport à la pièce à usiner dans au moins une direction,
l'unité de déplacement (56, 57) étant configurée pour se déplacer dans une direction X,
dans lequel les recouvrements d'air chaud (700) sont agencés pour être déplacés conjointement avec la buse d'injection,
dans lequel une extrémité des recouvrements d'air chaud (700) qui est opposée à la pièce à usiner est ouverte,
dans lequel les recouvrements d'air chaud (700) sont disposés sur des côtés opposés de la buse d'injection (500) dans la direction X de façon à enserrer la buse d'injection (500).

2. Dispositif de retrait de substances en adhérence selon la revendication 1, dans lequel l'unité d'injection de matière particulaire (500) injecte la matière particulaire de façon à être inclinée par rapport à une face sur laquelle les substances en adhérence adhèrent dans la pièce à usiner (30).

3. Dispositif de retrait de substances en adhérence selon la revendication 1 ou 2, comprenant en outre un recouvrement (520D) configuré pour couvrir au moins la buse d'injection (500) de l'unité d'injection de matière particulaire et l'atmosphère dans laquelle la matière particulaire est injectée sur la pièce à usiner, et pour être ouvert vers la pièce à usiner (30).

4. Dispositif de retrait de substances en adhérence selon la revendication 3, comprenant en outre une unité d'aspiration configurée pour être reliée au recouvrement (520D) et pour aspirer un matériau dans le recouvrement.

5. Dispositif de retrait de substances en adhérence selon l'une quelconque des revendications 1 à 4, dans lequel le dispositif de chauffage est configuré pour chauffer le gaz sec.

6. Dispositif de retrait de substances en adhérence selon l'une quelconque des revendications 1 à 5, dans lequel le dispositif de retrait de substances en adhérence comprend une pluralité d'unités d'injection de matière particulaire (500).

7. Dispositif de retrait de substances en adhérence selon la revendication 6, dans lequel la pluralité d'unités d'injection de matière particulaire (500) est montée vers le point prédéterminé de la pièce à usiner à différents angles solides.

8. Système de dépôt en phase vapeur comprenant :
le dispositif de retrait de substances en adhérence selon l'une quelconque des revendications 1 à 7 ; et
un appareil de dépôt en phase vapeur (4) configuré pour déposer un matériau de dépôt sur un matériau cible de dépôt (32) qui est supporté et transporté par un support qui est la pièce à usiner (30).

9. Système de dépôt en phase vapeur selon la revendication 8, comprenant en outre une unité de retrait de résidu configurée pour être disposée en aval dans une direction de transport du support par rapport au dispositif de retrait de substances en adhérence et pour retirer un résidu restant sur le support duquel les substances en adhérence ont été retirées par le dispositif de retrait de substances en adhérence.
